Europäisches Patentamt

European Patent Office

Office européen des brevets

(19)

(11) EP 0 650 772 B1

(12) **FASCICULE DE BREVET EUROPEEN**

(45) Date de publication et mention
de la délivrance du brevet:
**21.11.2001 Bulletin 2001/47**

(51) Int Cl.7: **B05D 7/24**, C23C 14/12,
C08J 7/00, B05D 3/14

(21) Numéro de dépôt: **94402111.2**

(22) Date de dépôt: **22.09.1994**

(54) **Procédé de dépôt d'une couche mince sur la surface d'un substrat en matière plastique**

Verfahren zum Aufbringen einer dünnen Schicht auf der Oberfläche eines Kunststoffsubstrat

Process for depositing a thin layer on a plastic substrate

(84) Etats contractants désignés:
**AT BE CH DE DK ES FR GB GR IE IT LI LU NL PT
SE**

(30) Priorité: **29.10.1993 FR 9312946**

(43) Date de publication de la demande:
**03.05.1995 Bulletin 1995/18**

(73) Titulaire: **Atofina
92800 Puteaux (FR)**

(72) Inventeurs:
• **Verzaro, Francis
F-64121 Serres Castet (FR)**

• **Ferry, Didier
F-64170 Artix (FR)**

(74) Mandataire: **Luziau, Nelly
Atofina,
D.P.I.
4-8 Cours Michelet,
La Défense 10
92091 Paris La Défense Cedex (FR)**

(56) Documents cités:
**EP-A- 0 110 258         EP-A- 0 252 870
EP-A- 0 254 205         WO-A-85/04601
CA-A- 1 266 591         DE-A- 4 204 082**

## Description

L'invention concerne un procédé de dépôt par polymérisation-plasma d'une couche ou d'un film protecteur sur la surface d'un substrat en matière plastique.

Des substrats plastiques revêtus d'une couche mince haute barrière aux gaz (oxygène, vapeur d'eau) ont été obtenus par des techniques plasma.

Ainsi, on connaît des substrats plastiques revêtus d'une couche de type "silice" dont l'intérêt par rapport aux matériaux barrière aux gaz existants réside dans les points suivants : les films présentent des caractéristiques haute barrière aux gaz égales ou supérieures à des matériaux barrière tels que le PVDC (polyvinylidène dichlorure) ou l'EVOH (polyéthylène-alcool vinylique). Ils résistent à des traitements thermiques ultérieurs comme la stérilisation et ils sont transparents au rayonnement micro-onde (à cause de leur résistivité électrique élevée). Ces films haute barrière sont destinés à l'industrie de l'emballage alimentaire, où les exigences en matière d'effet haute barrière aux gaz ($O_2$, vapeur d'eau, $CO_2$) sont de plus en plus sévères.

Ces dépôts-plasma, outre leur propriété haute barrière, peuvent également trouver des débouchés dans le domaine notamment de la protection à la rayure de matériaux plastiques, grâce notamment au fait qu'ils sont réticulés, ce qui leur confère une dureté importante.

Le dépôt de couches minces par polymérisation-plasma se réfère à une technique consistant à former un film à la surface d'un substrat, à partir de molécules dites polymérisables introduites dans le gaz plasmagène (exemple : hydrocarbures saturés ou insaturés). Dans un processus de polymérisation-plasma, la molécule de départ (ou monomère) interagit en phase gazeuse avec des espèces énergétiques (électrons, ions, photons) provoquant la cassure des liaisons chimiques et donnant ainsi naissance à des radicaux libres. Ces radicaux libres créés en phase gazeuse peuvent venir s'adsorber à la surface du substrat et se lier entre eux pour "polymériser".

Le revêtement ou film formé est appelé film-plasma ou dépôt-plasma.

Une autre technique de dépôt de couches protectrices qui donne de bons résultats est celle utilisant les vernis. Cependant, les avantages du procédé plasma par rapport au vernis sont multiples. Ainsi, le procédé plasma est un procédé par voie sèche, contrairement aux procédés utilisant des vernis dits procédés par voie humide, dans lesquels on associe le monomère à appliquer à un ou plusieurs solvants pour des raisons de viscosité. Ces procédés nécessitent des conditions de mise en oeuvre sévères, notamment en salles hors poussières à température et hygrométrie contrôlées.

Cet aspect "technologie de dépôt à caractère propre et non polluant" du procédé plasma n'est pas à négliger aujourd'hui et pour le futur, compte tenu des réglementations existantes ou en cours de mise en place dans le domaine de l'environnement.

En outre, l'application des vernis sur des pièces de forme complexe (phares arrières de voiture par exemple) se prête difficilement à l'obtention de couches d'épaisseur homogène.

Par contre, le dépôt de couche par polymérisation-plasma permet d'atteindre cette exigence sur ce type de pièce : en effet, la pièce "baignant" dans l'atmosphère gazeuse du plasma est accessible en chacun de ses points par les molécules gazeuses excitées, dans la mesure où la mécanique des fluides du système a été correctement appréhendée.

Cependant, dès l'origine de l'utilisation de la technique de dépôt par plasma, des problèmes d'adhérence de la couche mince au substrat plastique sur lequel elle est déposée, ont été constatés, et de nombreuses tentatives ont été faites depuis pour éviter ces défauts.

Le document US-A-4 830 873 décrit un procédé de dépôt d'un film "dur" résistant à la rayure, de préférence sur du polycarbonate, par polymérisation-plasma, consistant à démarrer le procédé en formant une pré-couche à partir du monomère devant former la couche ultérieure, puis à incorporer l'oxygène de façon progressive (pendant quelques minutes) jusqu'à atteindre les proportions requises dans le mélange gazeux afin de réaliser ensuite le film "dur". Selon ce document, lorsqu'il est introduit au début du procédé, l'oxygène est néfaste à l'adhérence ultérieure couche dure/substrat.

Le document EP-A-0254 205 décrit un procédé de fabrication de couches protectrices transparentes à base de composés silicieux, de préférence sur du polyallyldiglycolcarbonate. Le plasma utilisé est à base d'hexaméthyldisiloxane (HMDS) et d'oxygène et obtenu dans un réacteur radio-fréquence à couplage capacitif. Le substrat est disposé sur l'électrode connectée au générateur de fréquence (ou cathode).

L'examen de l'état de la technique indique un certain nombre d'exemples de dépôts-plasma présentant une adhérence correcte, obtenus principalement sur polycarbonate.

Les procédés ne donnent pas de résultats satisfaisants avec le polyméthacrylate de méthyle et on cherche toujours à améliorer encore l'adhérence de ces couches sur d'autres substrats en matière plastique. L'objet de l'invention est donc un procédé de dépôt par polymérisation-plasma d'une couche ou d'un film protecteur sur la surface d'un substrat en matière plastique, cette couche ou film présentant une bonne adhérence sur ledit substrat. Plus particulièrement, le but de la présente invention est un procédé de dépôt d'un tel film ou couche comportant au moins une étape de pré-traitement du substrat en matière plastique, en vue d'améliorer l'adhérence du film ou couche sur le substrat en matière plastique.

Le document EP-A- 0110258 décrit le dépôt d'une couche d'un composé organosilane sur un substrat (PVC) comme précouche avant la métallisation. Avant le dépôt de cette précouche d'organosilane, on peut traiter le substrat par plasma basse température en atmosphère d'un gaz minéral pour améliorer l'adhérence de la couche métallique sur le substrat. Ce prétraitement a lieu dans les mêmes conditions que celles du dépôt du composé organosilane.

A cet effet, l'invention concerne un procédé de dépôt par polymérisation-plasma d'une couche ou d'un film protecteur sur la surface d'un substrat en matière plastique, dans lequel on soumet le substrat à un plasma obtenu dans un réacteur sous vide primaire par décharge électrique dans un milieu gazeux qui est caractérisé en ce qu'il comporte au moins les étapes suivantes :

a) pré-traitement dudit substrat en matière plastique consistant à le disposer sur un porte-substrat peu ou pas polarisé, à le soumettre à un plasma constitué d'au moins un gaz de pré-traitement permettant l'apport d'oxygène sous une forme susceptible d'activer la surface dudit substrat et à fournir au milieu gazeux de pré-traitement au moyen de ce plasma, une quantité d'énergie minimale pour créer la quantité d'oxygène susceptible d'activer la surface du substrat, cette énergie étant fournie sous la forme d'une impulsion de densité de puissance électrique, la durée de cette impulsion étant de 1 seconde à 100 secondes, et la densité de puissance électrique étant d'au moins 50mW/cm$^3$.

b) dépôt de ladite couche ou dudit film sur la surface dudit substrat au moyen d'un plasma constitué d'un mélange gazeux de dépôt comportant au moins un gaz permettant l'apport d'oxygène et au moins un composé organosilicié.

On entend par "densité de puissance électrique" l'énergie électrique fournie par unité de volume de plasma et par unité de temps.

L'impulsion de densité de puissance électrique correspond à une énergie (produit d'une densité de puissance électrique par un temps), délivrée pendant un temps court, dit temps de pré-traitement.

Le porte-substrat est peu ou pas polarisé. Il peut être l'anode. En effet, si le pré-traitement selon l'invention s'effectue avec le substrat déposé à la cathode (électrode fortement polarisée), le résultat obtenu équivaut à un dépôt dans pré-traitement et il en résulte donc notamment une mauvaise adhérence de la couche plasma sur le substrat en matière plastique.

Le substrat ne doit donc pas être déposé à la cathode. Il ne doit pas subir un bombardement énergétique trop important de la part d'espèces chargées (ions) (quelques dizaines à quelques centaines de Volts ou d'électrons Volts).

Par contre, à l'anode, le substrat en matière plastique est à un potentiel dit flottant, faible comparé à celui ou ceux obtenu(s) à la cathode (de l'ordre de la dizaine de Volts ou moins).

La densité de puissance électrique pour le pré-

traitement a une valeur d'au moins 50mW/cm$^3$, avantageusement entre 80mW/cm$^3$ et 500mW/cm$^3$ et, plus particulièrement, de l'ordre de 165mW/cm$^3$ environ.

L'impulsion de densité de puissance électrique a une durée de 1 seconde environ à 100 secondes, notamment de 3 secondes environ à 50 secondes environ et, plus particulièrement, de l'ordre de 30 secondes.

Le gaz de pré-traitement peut être formé d'un gaz unique ou d'un mélange de gaz.

Dans le cas où un gaz de pré-traitement unique est utilisé dans le procédé selon l'invention, celui-ci est choisi dans le groupe incluant notamment l'oxygène, l'oxyde nitreux, le monoxyde et le dioxyde de carbone, l'eau et l'air. Ce peut être également, notamment, les gaz rares, l'azote, l'hydrogène qui sont susceptibles d'exciter l'oxygène résiduel présent dans le réacteur et d'apporter ainsi l'oxygène nécessaire à la mise en oeuvre du procédé conforme à l'invention. De manière préférée, on utilise l'oxygène comme gaz de pré-traitement dans le procédé selon l'invention.

Dans le cas où un mélange gazeux de pré-traitement est utilisé dans le procédé selon l'invention, celui-ci est constitué par au moins un des gaz choisis dans le groupe comprenant notamment l'oxygène, l'oxyde nitreux, le monoxyde et le dioxyde de carbone, l'eau, l'air, les gaz rares, l'azote, l'hydrogène ou équivalents.

Le gaz de pré-traitement peut comprendre, en outre, au moins un composé organosilicié choisi dans le groupe incluant notamment les silanes, les alcoxysilanes, les siloxanes, les silazanes, seuls ou en mélange entre eux, particulièrement l'hexaméthyldisiloxane.

Le mélange gazeux pour le dépôt de la couche ou du film comprend notamment comme précurseur de couches ou films de type SiO$_x$, un composé organosilicié choisi dans le groupe incluant notamment les silanes, les alcoxysilanes, les siloxanes, les silazanes, seuls ou en mélange entre eux. Selon l'invention, le composé organosilicié est de préférence l'hexaméthyldisiloxane (HMDS).

Le mélange gazeux de dépôt comprend, outre le composé organosilicié, au moins un gaz choisi dans le groupe incluant notamment l'oxygène, l'oxyde nitreux, le monoxyde ou le dioxyde de carbone, l'eau, l'air, les gaz rares, l'azote, l'hydrogène ou équivalents, et de préférence l'oxygène.

Le gaz de pré-traitement peut-être identique ou différent du mélange gazeux de dépôt et le ou les composé(s) organosilicié(s) du gaz de pré-traitement est (sont) identique(s) ou différent(s) de celui (ceux) du mélange gazeux de dépôt.

La fréquence du générateur est comprise dans l'intervalle de O Hz (cas d'un générateur à courant continu) à quelques GHz, par exemple 2,45 GHz.

Le substrat en matière plastique est constitué par un polymère chargé ou non, choisi dans le groupe incluant notamment les polyoléfines, les polyacryliques, les polycarbonates, les polymères vinylaromatiques et, notamment, le polypropylène, le polystyrène, le polyméthacrylate de méthyle (PMMA).

Les polymères acryliques peuvent aussi être des copolymères formés à partir de méthacrylate de méthyle et de comonomères tels que acide (méth)acrylique, (méth)acrylates d'alkyle, (méth)acrylates d'hydroxyalkyle, (méth)acrylates d'alkoxyalkyle dans lesquels le groupe alkyle est, par exemple, de 1 à 8 atomes de carbone, (méth)acrylonitrile, (méth)acrylamide, maléimide, anhydride maléique, styrène substitué ou non, diène comme le butadiène.

Comme substrat pouvant être traité selon l'invention, on peut citer aussi les (co)polymères précédents imidés, par exemple des polymères à groupes glutarimides ; les copolymères imidés peuvent aussi comprendre des groupes méthacrylate de méthyle, acide méthacrylique, anhydride glutarique et, éventuellement, méthacrylamide, les groupes amide et imide pouvant porter des substituants identiques ou différents dans la même chaîne.

L'épaisseur de la couche ou du film protecteur peut varier suivant l'utilisation prévue. Ainsi, elle peut être de l'ordre de 0,1μm ou moins, lorsque le film est prévu comme barrière aux gaz. Elle peut être par exemple comprise entre 2,5μm et 25μm environ, plus particulièrement de l'ordre de 5μm, pour des films antirayures.

L'invention sera maintenant décrite sous forme d'exemples non limitatifs, donnés à titre uniquement descriptif.

Toutes les expériences ont été conduites en utilisant les mêmes conditions expérimentales, le même déroulement opératoire et les mêmes techniques d'analyses et de caractérisation.

## I CONDITIONS EXPERIMENTALES

*a) le réacteur*

Le réacteur utilisé est un réacteur à excitation radio-fréquence (R.F.), cylindrique, de 43 cm de diamètre et 19 cm de hauteur. Un manchon en pyrex placé à mi-hauteur permet de visualiser l'intérieur du réacteur, sur une hauteur de 10 cm. Le reste du réacteur est en aluminium.

Les électrodes, planes et parallèles, sont des disques d'un diamètre de 20 cm et distants l'un de l'autre de 3,5 cm. Elles sont en aluminium. L'une d'elles, appelée cathode, est soumise à l'excitation radio-fréquence de 13,56 MHz par l'intermédiaire d'un générateur à tension alternative. L'autre, appelée anode, est reliée à la masse. Cette électrode comprend un système de circulation de fluides, permettant de contrôler sa température ; ainsi, elle peut être refroidie par circulation d'eau froide. La puissance utile peut atteindre 300W. La puissance réfléchie permise est de 50W ; un adaptateur d'impédance permet de l'annuler de manière à obtenir un rendement maximal au niveau de la puissance fournie au plasma.

La mise sous vide du réacteur est assurée par un groupe de pompage, composé d'une pompe primaire et d'une pompe secondaire montée en amont de la pompe primaire, permettant d'obtenir un vide limite de 0,02Pa. Cette pression est mesurée par une jauge Penning. En ce qui concerne les pressions mesurées pendant le déroulement d'un essai, un manomètre à capacitance MKS dont la plage de mesure est comprise entre 0,013 P et 133 Pa, est utilisé. Un piège à azote liquide est interposé entre le réacteur et la pompe primaire afin de collecter les condensables et, ainsi, d'assurer un débit de pompage constant. Le débit nominal de la pompe primaire est de 22m$^3$/h.

*b) choix du monomère*

Le monomère utilisé pour l'obtention de dépôt de films types SiO$_x$ est l'hexaméthyldisiloxane (HMDS).

## II DEROULEMENT OPERATOIRE

*a) mise sous vide préalable du réacteur*

- vide primaire jusqu'à 0,67 Pa.

*b) effluvage sous plasma d'argon ou d'oxygène*

- pendant une durée de l'ordre de 10 à 20 minutes :
  Conditions d'effluvage sous plasma d'argon (exemples 2, 3) :

  - pAr= 17 Pa.
  - temps d'effluvage : 10 minutes
  - densité de puissance RF : 247,5 m W/cm3

  Conditions d'effluvage sous plasma d'oxygène (exemples 4,5,6,7 et 8)

  - pO$_2$ = 4,8 - 11,0 Pa.
  - temps d'effluvage : 10 -20 minutes
  - densité de puissance RF : 165 m W/cm3

*c) remise à la pression atmosphérique du réacteur et ouverture*
*d) positionnement du substrat à l'anode*
*e) mise sous vide préalable du réacteur*

- vide primaire jusqu'à 0,67 Pa.
- vide secondaire jusqu'à 0,02 Pa.

*f) pré-traitement*

avant dépôt de la couche ou du film sur la surface du substrat en matière plastique.

On introduit dans le réacteur le gaz de pré-traitement suivant un certain débit. On attend que la pression à l'intérieur du réacteur se stabilise. On déclenche le plasma pour une certaine valeur de la densité de puissance R.F. Le pré-traitement se fait pendant une durée courte variable. On peut éventuellement arrêter le générateur : dans ce cas, il n'y a plus de plasma.

On peut éventuellement arrêter l'arrivée de gaz avant d'introduire les gaz de dépôt et atteindre un vide de l'ordre de 0,67 Pa.

*g) dépôt de la couche plasma*

On introduit le ou les gaz qui serviront à l'obtention de la couche plasma. Cette introduction peut se faire avant le déclenchement du plasma, après avoir attendu la stabilisation de la pression totale, ou bien elle peut se faire à la fin de la phase de pré-traitement, le plasma étant, dans ce cas, encore en fonctionnement. On effectue le dépôt de la couche plasma pour atteindre une épaisseur finale d'environ 4.0 à 5.0 µm. Suivant les conditions de dépôt (pression de monomère, densité de puissance R.F.), les vitesses de dépôt pourront varier et conduire à des temps de dépôt plus ou moins longs (voir exemples). Dans le cas des dépôts correspondant à des temps relativement courts (une heure au moins dans les exemples 4, 5,6,7 et 8), le refroidissement de l'anode est mis en route environ 2 à 3 minutes après le début de cette phase de dépôt.

A la fin du dépôt, on coupe l'alimentation électrique et les arrivées de gaz. Les pressions relatives aux différents gaz introduits pendant la phase de dépôt ont été mesurées de la façon suivante : la pression est mesurée avant les étapes de pré-traitement et de dépôt, pour chacun des gaz, ceux-ci circulant seul dans le réacteur.

Dans les exemples donnés ici, les couches plasma déposées sont destinées à améliorer la résistance à l'abrasion d'un substrat plastique, en l'occurrence le polyméthacrylate de méthyle. Afin d'évaluer cette propriété, les résultats sont exprimés à partir du comportement au test d'abrasion Taber. Par ce test, est décrite l'adhérence de la couche plasma avec le substrat.

**III TEST DE RESISTANCE A L'ABRASION TABER ET MESURE DU "HAZE"**

Le test Taber est utilisé pour caractériser les propriétés de résistance à l'abrasion des revêtements. Il est normalisé (normes ASTM D-1044 ou DIN 52347E ou ISO 3537).

Deux meules abrasives (abrasif référence CS-10) surchargées de deux masselottes de 500g chacune reposent sur l'échantillon, lequel est posé sur une platine. Au cours de l'essai, la platine est mise en rotation (55 tr/mn). Grâce aux frottements avec l'échantillon, les meules tournent sur elles-mêmes. Plus le nombre de tours sera grand, plus l'usure par abrasion sera importante.

La détermination de l'abrasion est réalisée par une méthode optique utilisant un faisceau laser. Par cette méthode, on mesure la quantité de lumière du faisceau laser transmise à travers l'échantillon à analyser.

La grandeur caractéristique est le pourcentage de "Haze". Elle représente l'écart relatif entre la quantité de lumière transmise par la portion abrasée de l'échantillon (Ta) par rapport à sa portion non abrasée (To), c'est-à-dire le pourcentage de lumière diffusée par la surface abrasée de l'échantillon :

$$\% \text{ "Haze"} = \frac{To - Ta}{To} \times 100$$

Les valeurs de pourcentage de "Haze" indiquées dans les exemples représentent des valeurs moyennes sur 200 points de mesure d'intensité de lumière transmise. Ces points sont pris sur la partie abrasée de l'échantillon à analyser, celui-ci étant mis en rotation devant le faisceau laser. Une telle quantité de points peut être enregistrée grâce à un système d'acquisition de données (une mesure, toutes les 200 millisecondes).

Plus la valeur %"Haze" sera élevée, plus la résistance à la rayure de l'échantillon sera faible, et inversement.

Dans le cas d'un ensemble couche plasma/ substrat, l'aptitude à la résistance à l'abrasion donnée par le test de Taber est déterminée par :

- la dureté intrinsèque de la couche plasma,
- l'adhérence entre la couche plasma et le substrat.

Une mauvaise adhérence, induite sous l'effet des contraintes transmises par les meules abrasives à l'échantillon à analyser, conduit à des décollements de la couche plasma protectrice. Sur les zones où le substrat n'est plus protégé, l'abrasion augmente rapidement à chaque tour du test de Taber. En conséquence, la valeur moyenne %"Haze" calculée sur l'ensemble de la trace laissée par le passage des meules, augmente et traduit l'existence de cette perte d'adhérence.

D'autre part, il a été vérifié que, sur un substrat pour lequel l'adhérence entre couche plasma et substrat était satisfaisante (exemple, polycarbonate), la couche plasma déposée dans les conditions de dépôt indiquées dans les exemples présentait une dureté intrinsèque nettement suffisante. Les résultats obtenus au test de Taber sur polyméthacrylate de méthyle sont donc directement reliés à la qualité de l'adhérence couche plasma/ substrat.

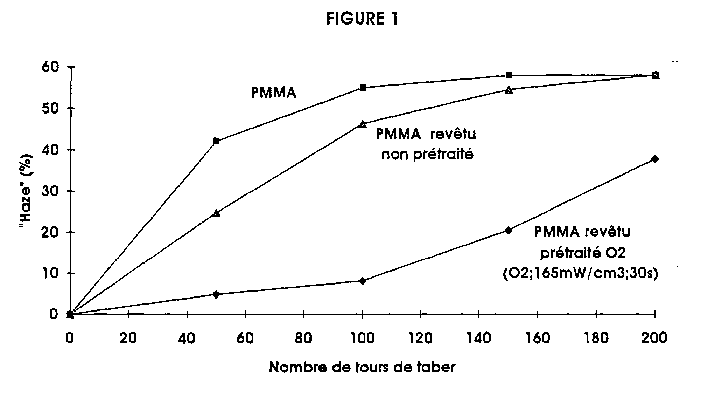

*La figure 1* est un graphe illustrant des résultats de tests de Taber effectués sur couches plasma déposées sur PMMA, l'une étant déposée sur PMMA prétraité par un plasma $O_2$ conformément au procédé selon l'invention, l'autre étant déposée sur PMMA non prétraité (exemple 2).

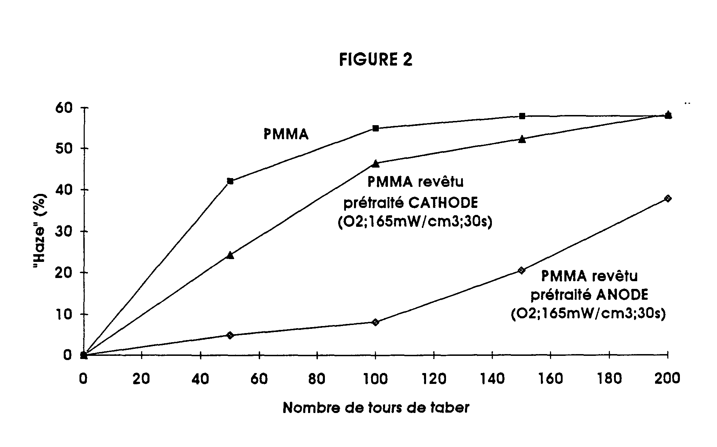

*La figure 2* est un graphe illustrant des résultats de tests de Taber effectués sur couches plasma déposées sur PMMA, l'une étant déposée sur PMMA prétraité à l'anode par un plasma d'$O_2$ conformément au procédé selon l'invention, l'autre étant déposée sur PMMA pré-traité à la cathode (non conforme à l'invention) par un plasma d'$O_2$ dans des conditions identiques (exemple 3).

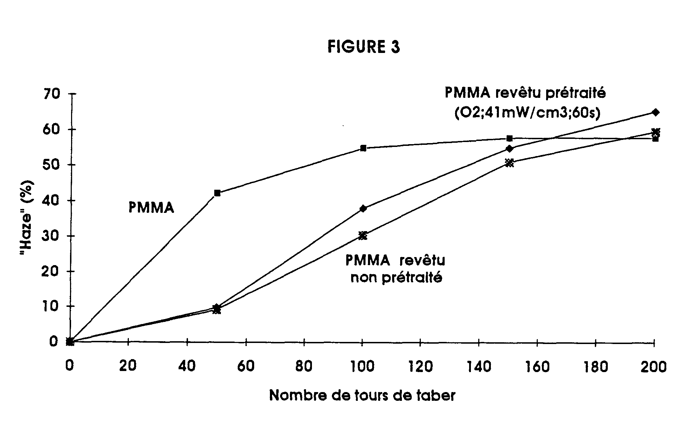

*La figure 3* est un graphe illustrant des résultats de tests de Taber effectués sur couches plasma déposées sur PMMA, l'une étant déposée sur PMMA prétraité dans des conditions non conformes au procédé suivant l'invention, en termes de densité de puissance et de temps de pré-traitement, l'autre étant déposée sur PMMA non pré-traité (exemple 4).

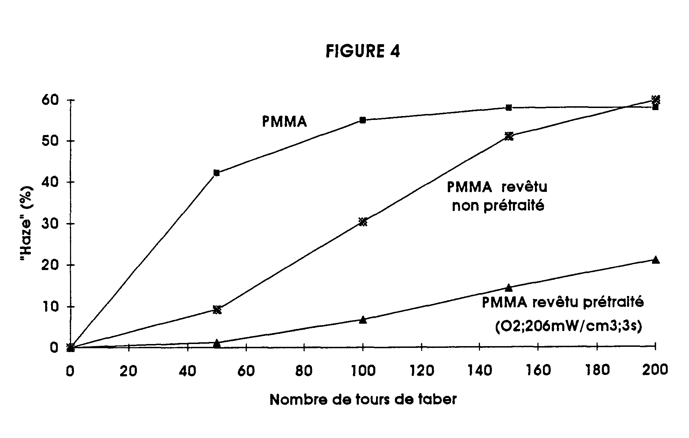

*La figure 4* est un graphe illustrant des résultats de tests de Taber effectués sur couches plasma déposées sur PMMA, l'une étant déposée sur PMMA prétraité par un plasma d'$O_2$ conformément au procédé suivant l'invention, dans des conditions différentes de pré-traitement de l'exemple 2, l'autre étant déposée sur PMMA non pré-traité (exemple 5).

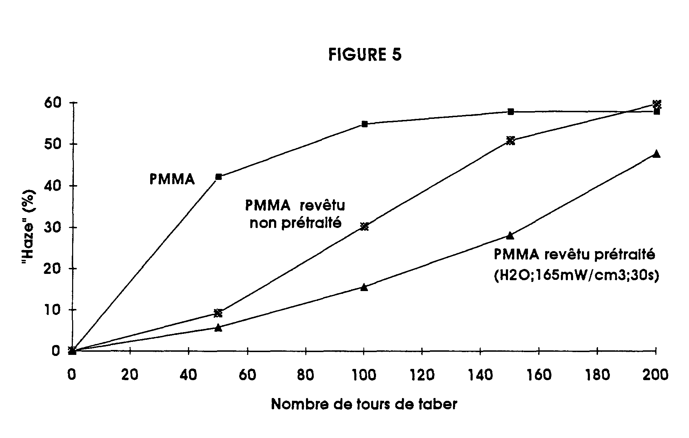

*La figure 5* est un graphe illustrant des résultats de tests de Taber effectués sur couches plasma déposées sur PMMA, l'une étant déposée sur PMMA prétraité par un plasma de vapeur d'eau conformément au procédé suivant l'invention, l'autre étant déposée sur PMMA non pré-traité (exemple 7).

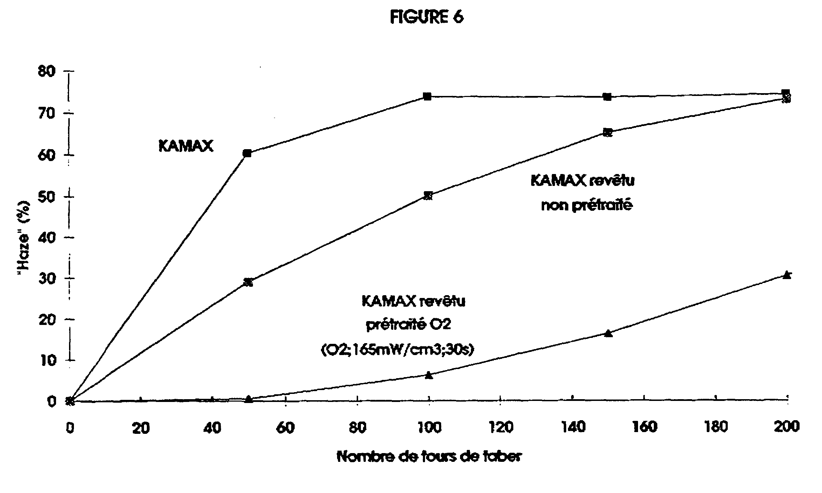

*La figure 6* est un graphe illustrant des résultats de tests de Taber effectués sur couches plasma déposées sur copolymères glutarimides/méthacrylate de méthyle, de dénomination commerciale KAMAX (ROHM & HAAS), l'une étant déposée sur KAMAX pré-traité par un plasma d'$O_2$ conformément au procédé suivant l'invention, l'autre étant déposée sur KAMAX non prétraité.

**Exemple 1** : **témoin**

Cet essai est effectué dans le réacteur décrit ci-dessus ; un substrat de polyméthacrylate de méthyle (PMMA) coulé, c'est-à-dire obtenu par polymérisation du monomère entre deux plaques de verre, est placé sur l'électrode reliée à la masse (anode).

*Conditions de pré-traitement suivant les recommandations faites dans le brevet US-A-4,830,873*

On introduit uniquement le monomère (HMDS) et on commence à déposer une pré-couche à partir de ce monomère pendant 60 secondes :

- pHMDS : 3,3 Pa
- Temps de pré-traitement : 60 secondes
- Densité de puissance R.F. : 41mW/cm$^3$

*Conditions de dépôt*

A partir de 30 secondes, on commence à in-troduire progressivement l'oxygène ($O_2$) et l'hélium (He), gaz qui participent à l'obtention de la dureté de la couche.

- pHe: 24,7 Pa    • p$O_2$: 6,7 Pa    • pHMDS : 3,3 Pa
- Temps de dépôt : 180 mn
- Densité de puissance R.F. : 41mW/cm$^3$

L'épaisseur de la couche-plasma correspondante est de 4,1 μm.

On constate, en sortie de réacteur, un décollement de la couche-plasma déposée de son substrat PMMA.

Des temps de pré-traitement de 5 et 10 mn ont été essayés.

On constate toujours, après dépôt du film-plasma, ce manque d'adhérence sur PMMA.

**Exemple 2**

Cet essai a été effectué dans le même réacteur que l'exemple 1. Un substrat de PMMA coulé est disposé sur l'électrode reliée à la masse (anode).

*Conditions de pré-traitement*

- p$O_2$ : 6,5 Pa
- Temps de pré-traitement : 30 secondes
- Densité de puissance R.F. : 165 mW/cm$^3$

*Conditions de dépôt*

Ce sont les mêmes que celles indiquées dans l'exemple 1. L'épaisseur du film-plasma correspondant est de 4,0 μm.

Le résultat au test de Taber est illustré par la figure 1 qui comporte également, à titre comparatif, les résultats au test de Taber du PMMA revêtu par dépôt-plasma sans pré-traitement (dans les mêmes conditions de dépôt que celles de l'exemple 1), et du PMMA non revêtu, non pré-traité.

On constate, par rapport à un dépôt-plasma sans pré-traitement, une amélioration de la résistance à l'abrasion lorsque le PMMA est pré-traité dans un plasma d'oxygène dans les conditions de pré-traitement selon l'invention.

Ce résultat, obtenu grâce à une amélioration de l'adhérence entre la couche plasma et le substrat, montre que la présence d'oxygène dans la phase de pré-traitement est bénéfique, à condition de choisir les conditions de pré-traitement les plus appropriées (forte densité de puissance, temps de pré-traitement court), selon l'invention.

**Exemple 3 : témoin**

Cet essai a été effectué dans le même réacteur que l'exemple 1. Un substrat de PMMA coulé est disposé pendant la phase de pré-traitement, sur l'électrode excitatrice (cathode) fortement polarisée, puis pendant la phase de dépôt sur l'électrode reliée à la masse (anode).

*Conditions de pré-traitement*

- pO$_2$ : 5,7 Pa
- Temps de pré-traitement : 30 secondes
- Densité de puissance R.F. : 165 mW/cm3
- Potentiel d'auto-polarisation de la cathode : 530 Volts

*Conditions de dépôt*

Ce sont les mêmes que celles indiquées dans l'exemple 1. L'épaisseur du film-plasma correspondant est de 4,1 μm.

Le résultat au test de Taber est illustré par la figure 2 qui comporte également, à titre comparatif, les résultats au test de Taber du PMMA revêtu par dépôt-plasma avec pré-traitement effectué à l'anode (potentiel de polarisation nul et conditions de pré-traitement et de dépôt de l'exemple 2), et du PMMA non revêtu et non pré-traité.

On constate que l'effet du prétraitement, dans des conditions conformes à l'invention, est annulé lorsque le substrat est disposé à la cathode : il n'y a aucune adhérence entre la couche plasma et le substrat.

Ce résultat indique donc l'importance de la polarisation du porte-substrat lors de la phase de pré-traitement du substrat PMMA ; ce point n'a pas été mis en évidence dans le document EP-A-0254205.

**Exemple 4**

Cet essai a été effectué dans le même réacteur que l'exemple 1. Un substrat de PMMA coulé est disposé sur l'électrode reliée à la masse (anode).

*Conditions de pré-traitement*

- pO$_2$ : 6,7 Pa
- Temps de pré-traitement : 60 secondes
- Densité de puissance R.F. : 41 mW/cm$^3$

*Conditions de dépôt*

- pHMDS : 7,2 Pa pO$_2$ : 4,8 Pa
- Temps de dépôt : 59 mn
- Densité de puissance R.F. : 206 mW/cm$^3$

L'épaisseur du film-plasma correspondant est de 5,5 μm.

Le résultat au test de Taber est illustré par la figure 3 qui comporte également, à titre comparatif, les résultats au test de Taber du PMMA revêtu plasma, non pré-traité (avec les mêmes conditions de dépôt que celles de l'exemple 4) et du PMMA non revêtu plasma et non pré-traité.

Ce résultat montre que, si des conditions de pré-traitement correspondant à une densité de puissance faible (41 mW/cm$^3$) et de temps relativement long (60 secondes) sont utilisées, aucune amélioration de la résistance à l'abrasion n'est constatée par rapport au substrat PMMA revêtu du même film plasma, et non pré-traité : ceci est dû à une mauvaise adhérence entre la couche plasma et le substrat.

Seules, des conditions de pré-traitement selon l'invention, (densité de puissance élevée delivrée pendant un temps court) conduisent à une amélioration de l'adhérence et, par conséquent, à une amélioration significative de la résistance à l'abrasion.

**Exemple 5**

Cet essai a été effectué dans le même réacteur que l'exemple 1. Un substrat de PMMA coulé est disposé sur l'électrode reliée à la masse (anode).

*Conditions de pré-traitement*

- pO$_2$ : 4,8 Pa
- Temps de pré-traitement : 3 secondes
- Densité de puissance R.F. : 206 mW/cm$^3$

*Conditions de dépôt*

Les mêmes que celles indiquées dans l'exemple 4, sauf le temps de dépôt qui est égal à 50 mn. L'épaisseur du film-plasma correspondant est dans ce cas de 4,7 μm.

Le résultat au test de Taber est illustré par la figure 4 qui comporte également, à titre comparatif, les résultats au test de Taber du PMMA revêtu plasma non pré-traité (avec les mêmes conditions de dépôt que celles de l'exemple 4) et du PMMA non revêtu plasma et non pré-traité.

Ce résultat confirme l'importance des conditions de pré-traitement selon l'invention (forte densité de puissance délivrée pendant un temps court) pour l'adhérence couche plasma/substrat et, par conséquent, pour la résistance à l'abrasion de cet ensemble.

## Exemple 6 : témoin

Cet essai a été effectué dans le même réacteur que l'exemple 1. Un substrat de PMMA coulé est disposé sur l'électrode reliée à la masse (anode). Dans cet exemple, le gaz de pré-traitement utilisé est la vapeur d'eau.

### Conditions de pré-traitement

- $pH_2O$ : 6,3 Pa
- Temps de pré-traitement : 300 secondes
- Densité de puissance R.F. : 49.5 mW/cm$^3$

### Conditions de dépôt

Le monomère (HMDS) est introduit dans le plasma de vapeur d'eau. La densité de puissance RF est augmentée et fixée à 206 mW/cm$^3$. Puis, la vapeur d'eau est remplacée par l'oxygène. Ces opérations se font en un temps court (quelques dizaines de secondes). Ensuite, le dépôt se fait, dans sa majeure partie, dans des conditions analogues à celles décrites dans l'exemple 4, sauf que le temps total de dépôt est de 50 mn.

La mesure de l'épaisseur du film-plasma n'a pu être effectuée à cause du décollement dudit film de son substrat PMMA.

Cet exemple montre que des conditions de pré-traitement correspondant à une densité de puissance faible délivrée pendant un temps long ne conduisent pas à une adhérence correcte entre film-plasma et PMMA, même avec un autre gaz de pré-traitement que l'oxygène moléculaire.

## Exemple 7

Cet essai a été effectué dans le même réacteur que l'exemple 1. Un substrat de PMMA coulé est disposé sur l'électrode reliée à la masse (anode). Dans cet exemple, le gaz de pré-traitement utilisé est la vapeur d'eau. Les conditions de pré-traitement sont celles définies dans l'invention.

### Conditions de pré-traitement

- $pH_2O$ : 5,2 Pa
- Temps de pré-traitement : 30 secondes
- Densité de puissance R.F. : 165 mW/cm$^3$

### Conditions de dépôt

Le monomère (HMDS) est introduit dans le plasma de vapeur d'eau. La densité de puissance RF passe à 206 mW/cm$^3$. Puis, la vapeur d'eau est remplacée par l'oxygène. Ces opérations se font en un temps court (quelques dizaines de secondes). Ensuite, le dépôt se fait dans sa majeure partie dans des conditions analogues à celles décrites dans l'exemple 4, sauf que le temps total de dépôt est de 60 mn.

L'épaisseur du film-plasma correspondant est, dans ce cas, de 5.0 µm.

Le résultat au test de Taber est illustré par la figure 5 qui comporte également, à titre comparatif, les résultats au test de Taber du PMMA revêtu plasma non pré-traité (avec les mêmes conditions de dépôt que celles de l'exemple 4) et du PMMA non revêtu plasma et non pré-traité.

Ce résultat confirme l'importance des conditions de pré-traitement selon l'invention (forte densité de puissance délivrée pendant un temps court) pour obtenir une bonne adhérence du dépôt sur le substrat PMMA.

## Exemple 8

Cet essai a été effectué dans le même réacteur que celui de l'exemple 1. Le substrat est une plaque obtenue par injection en copolymère glutarimide/méthacrylate de méthyle, commercialisé sous la dénomination KAMAX par la société ROHM & HAAS. Ce substrat est disposé sur l'électrode reliée à la masse (anode).

### Conditions de pré-traitement

- $pO_2$: 10,9 Pa
- Temps de pré-traitement : 30 secondes
- Densité de puissance R.F. : 165 mW/cm$^3$

### Conditions de dépôt

- pHMDS : 8,0 Pa $pO_2$ : 10,9 Pa
- Temps de dépôt : 82 mn
- Densité de puissance R.F. : 206 mW/cm$^3$

L'épaisseur du film-plasma correspondant est de 5,2 µm.

Le résultat au test de Taber est illustré par la figure 6 qui comporte également, à titre comparatif, les résultats au test de Taber du KAMAX, revêtu plasma, non pré-traité (avec les mêmes conditions de dépôt que celles données ci-dessus) et du KAMAX non revêtu plasma et non pré-traité. Ce résultat montre l'influence du pré-traitement, effectué dans des conditions de pré-traitement selon l'invention, sur l'adhérence film-plasma/substrat.

## Revendications

1. Procédé de dépôt par polymérisation-plasma d'une couche ou d'un film protecteur sur la surface d'un substrat en matière plastique, dans lequel on soumet le substrat à un plasma obtenu dans un réacteur sous vide primaire par décharge électrique dans un milieu gazeux, **caractérisé en ce qu'**il comporte au moins les étapes suivantes :

   a) pré-traitement dudit substrat en matière plastique consistant à le disposer sur un porte-substrat peu ou pas polarisé, à le soumettre à un plasma constitué d'au moins un gaz de pré-traitement permettant l'apport d'oxygène sous une forme susceptible d'activer la surface dudit substrat et à fournir au milieu gazeux de pré-traitement au moyen de ce plasma, une quantité d'énergie minimale pour créer la quantité d'oxygène susceptible d'activer la surface du substrat, cette énergie étant fournie sous la forme d'une impulsion de densité de puissance électrique, la durée de cette impulsion étant de 1 seconde à 100 secondes, et la densité de puissance électrique étant d'au moins 50mW/cm$^3$.
   b) dépôt de ladite couche ou dudit film sur la surface dudit substrat au moyen d'un plasma constitué d'un mélange gazeux de dépôt comportant au moins un gaz permettant l'apport d'oxygène et au moins un composé organosilicié.

2. Procédé conforme à la revendication 1, **caractérisé en ce que** le porte-substrat est l'anode.

3. Procédé selon la revendication 1 ou 2 **caractérisé en ce que** la densité de puissance électrique est comprise entre 80 mW/cm$^3$ et 500 mw/cm$^3$, plus particulièrement, est de l'ordre de 165 mW/cm$^3$.

4. Procédé selon l'une des revendications 1 à 3, **caractérisé en ce que** l'impulsion de densité de puissance électrique a une durée de 3 secondes environ à 50 secondes environ, et, plus particulièrement, de l'ordre de 30 secondes.

5. Procédé selon l'une quelconque des revendications 1 à 4, **caractérisé en ce que** le gaz de pré-traitement est choisi dans le groupe incluant notamment l'oxygène, l'oxyde nitreux, le monoxyde ou le dioxyde de carbone, l'eau, l'air, les gaz rares, l'azote, l'hydrogène ou leur mélange.

6. Procédé selon l'une quelconque des revendications 1 à 5 **caractérisé en ce que** le gaz de pré-traitement comprend, en outre, au moins un composé organosilicié choisi dans le groupe incluant notamment les silanes, les alcoxysilanes, les siloxanes, les silazanes, seuls ou en mélange entre eux.

7. Procédé selon la revendication 6, **caractérisé en ce que** le gaz de pré-traitement comprend de l'hexaméthyldisiloxane.

8. Procédé selon l'une quelconque des revendications 1 à 7, **caractérisé en ce que** le mélange gazeux de dépôt comprend au moins un composé organosilicié et au moins un gaz choisi dans le groupe incluant notamment l'oxygène, l'oxyde nitreux, le monoxyde ou le dioxyde de carbone, l'eau, l'air, les gaz rares, l'azote, l'hydrogène.

9. Procédé selon la revendication 8, **caractérisé en ce que** le composé organosilicié est choisi dans le groupe incluant notamment les silanes, les alcoxysilanes, les siloxanes, les silazanes, seuls ou en mélange entre eux.

10. Procédé selon la revendication 9, **caractérisé en ce que** le composé organosilicié est de l'héxaméthyldisiloxane.

11. Procédé selon l'une quelconque des revendications 5 à 10, **caractérisé en ce que** le gaz de pré-traitement est identique ou différent du mélange gazeux de dépôt.

12. Procédé selon l'une quelconque des revendications 6 à 11, **caractérisé en ce que** le ou les composé(s) organosilicié(s) du gaz de pré-traitement est (sont) identique(s) ou différent(s) de celui (ceux) du mélange gazeux de dépôt.

13. Procédé selon l'une quelconque des revendications 1 à 12, **caractérisé en ce que** la fréquence du générateur est comprise dans l'intervalle de 0 Hz à quelques GHz.

14. Procédé selon l'une quelconque des revendications 1 à 13, **caractérisé en ce que** le substrat en matière plastique est constitué par un polymère chargé ou non, choisi dans le groupe incluant notamment les polyoléfines, les polyacryliques, les polycarbonates, les polymères vinylaromatiques.

15. Procédé selon la revendication 14, **caractérisé en ce que** le substrat est choisi dans le groupe formé par du polypropylène, du polystyrène, un polymère de méthacrylate de méthyle.

16. Procédé selon la revendication 14, **caractérisé en**

**ce que** le substrat en matière plastique est un copolymère formé à partir de méthacrylate de méthyle et de comonomères choisis dans le groupe formé par l'acide (méth)acrylique, les (méth)acrylates d'hydroxyalkyle, les (méth)acrylates d'alkoxyalkyle dans lesquels le groupe alkyle a de 1 à 8 atomes de carbone, les (méth)acrylonitrile, (méth)acrylamide, maléimide, anhydride maléique,styrène substitué ou non, les diènes.

17. Procédé selon la revendication 14, **caractérisé en ce que** le substrat est un polymère à groupes glutarimides.

## Claims

1. Process for deposition, by plasma polymerization, of a protective layer or film on the surface of a plastic substrate, in which the substrate is exposed to a plasma obtained in a low-vacuum reactor by electrical discharge in a gaseous medium, **characterized in that** it comprises at least the following steps:

   a) pretreatment of the said plastic substrate, consisting in placing it on a substrate holder which may or may not be slightly biased, then exposing it to a plasma consisting of at least one pretreatment gas allowing oxygen to be provided in a form capable of activating the surface of the said substrate and in delivering, to the gaseous medium for pretreatment by means of this plasma, a minimum amount of energy in order to create the amount of oxygen capable of activating the surface of the substrate, this energy being delivered in the form of an electrical power density pulse, the duration of this pulse being from 1 second to 100 seconds, and the electrical power density being at least 50 mW/cm$^3$;
   b) deposition of the said layer or the said film on the surface of the said substrate by means of a plasma consisting of a deposition gas mixture comprising at least one gas allowing oxygen to be provided and at least one organosilicon compound.

2. Process according to Claim 1, **characterized in that** the substrate holder is the anode.

3. Process according to Claim 1 or 2, **characterized in that** the electrical power density is between 80 mW/cm$^3$ and 500 mW/cm$^3$ and more particularly is around 165 mW/cm$^3$.

4. Process according to one of Claims 1 to 3, **characterized in that** the electrical power density pulse has a duration of about 3 seconds to about 50 seconds, and more particularly around 30 seconds.

5. Process according to any one of Claims 1 to 4, **characterized in that** the pretreatment gas is chosen from the group including, especially, oxygen, nitrous oxide, carbon monoxide or dioxide, water, air, the rare gases, nitrogen, hydrogen or a mixture thereof.

6. Process according to any one of Claims 1 to 5, **characterized in that** the pretreatment gas furthermore comprises at least one organosilicon compound chosen from the group including, especially, silanes, alkoxysilanes, siloxanes, silazanes, by themselves or as a mixture thereof.

7. Process according to Claim 6, **characterized in that** the pretreatment gas comprises hexamethyldisiloxane.

8. Process according to any one of Claims 1 to 7, **characterized in that** the deposition gas mixture comprises at least one organosilicon compound and at least one gas chosen from the group including, especially, oxygen, nitrous oxide, carbon monoxide or dioxide, water, air, the rare gases, nitrogen, hydrogen.

9. Process according to Claim 8, **characterized in that** the organosilicon compound is chosen from the group including, especially, silanes, alkoxysilanes, siloxanes, silazanes, by themselves or as a mixture thereof.

10. Process according to Claim 9, **characterized in that** the organosilicon compound is hexamethyldisiloxane.

11. Process according to any one of Claims 5 to 10, **characterized in that** the pretreatment gas is identical to or different from the deposition gas mixture.

12. Process according to any one of Claims 6 to 11, **characterized in that** the organosilicon compound or compounds of the pretreatment gas is (are) identical to or different from that (those) of the deposition gas mixture.

13. Process according to any one of Claims 1 to 12, **characterized in that** the frequency of the generator lies within the range from 0 Hz to a few GHz.

14. Process according to any one of Claims 1 to 13, **characterized in that** the plastic substrate is made of a filled or unfilled polymer chosen from the group including, especially, polyolefins, polyacrylics, polycarbonates and vinylaromatic polymers.

**15.** Process according to Claim 14, **characterized in that** the substrate is chosen from the group formed by polypropylene, polystyrene and a methyl methacrylate polymer.

**16.** Process according to Claim 14, **characterized in that** the plastic substrate is a copolymer formed from methyl methacrylate and comonomers which are chosen from the group formed by (meth)acrylic acid, hydroxyalkyl (meth)acrylates, alkoxyalkyl (meth)acrylates in which the alkyl group has from 1 to 8 carbon atoms, (meth)acrylonitrile, (meth)acrylamide, maleimide, maleic anhydride, substituted or unsubstituted styrene, and dienes.

**17.** Process according to Claim 14, **characterized in that** the substrate is a polymer having glutarimide groups.

**Patentansprüche**

**1.** Verfahren zur Ablagerung durch Plasma-Polymerisation einer Schutzschicht oder eines Schutzfilms auf der Oberfläche eines Substrats aus Kunststoff, bei dem man das Substrat einem Plasma aussetzt, das in einem Reaktor unter Grobvakuum durch elektrische Entladung in einem gasförmigen Milieu hergestellt wurde, **dadurch gekennzeichnet, daß** es mindestens die folgenden Schritte umfaßt:

a) eine Vorbehandlung des genannten Substrats aus Kunststoff, die darin besteht, es auf einem gering- oder nichtpolarisierten Substratträger anzuordnen, es einem Plasma auszusetzen, das aus mindestens einem Vorbehandlungsgas besteht, das die Sauerstoffzufuhr in einer Form erlaubt, die geeignet ist, die Oberfläche des genannten Substrats zu aktivieren, und dem gasförmigen Vorbehandlungsmilieu mit Hilfe dieses Plasmas eine minimale Energiemenge zu liefern, um die Sauerstoffmenge zu erzeugen, die geeignet ist, die Substratoberfläche zu aktivieren, wobei diese Energie in Form eines elektrischen Leistungsdichte-Impulses geliefert wird, wobei die Dauer dieses Impulses von 1 Sekunde bis zu 100 Sekunden reicht und die elektrische Leistungsdichte mindestens 50 mW/cm$^3$ beträgt,

b) eine Ablagerung der genannten Schicht oder des genannten Films auf der Oberfläche des genannten Substrats mit Hilfe eines Plasmas, das aus einem Ablagerungsgasgemisch besteht, das mindestens ein die Sauerstoffzufuhr erlaubendes Gas, und mindestens eine Organosiliciumverbindung enthält.

**2.** Verfahren nach Anspruch 1, **dadurch gekennzeichnet, daß** der Substratträger die Anode ist.

**3.** Verfahren nach Anspruch 1 oder 2, **dadurch gekennzeichnet, daß** die elektrische Leistungsdichte zwischen 80 mW/cm$^3$ und 500 mW/cm$^3$ liegt und noch spezieller etwa 165 mW/cm$^3$ beträgt.

**4.** Verfahren nach einem der Ansprüche 1 bis 3, **dadurch gekennzeichnet, daß** der elektrische Leistungsdichte-Impuls eine Dauer von ungefähr 3 Sekunden bis ungefähr 50 Sekunden und noch spezieller von etwa 30 Sekunden hat.

**5.** Verfahren nach irgendeinem der Ansprüche 1 bis 4, **dadurch gekennzeichnet, daß** das Vorbehandlungsgas aus der Gruppe gewählt ist, die insbesondere Sauerstoff, Stickstoffoxid, Kohlenmonoxid oder -dioxid, Wasser, Luft, die Edelgase, Stickstoff, Wasserstoff oder deren Gemische einschließt.

**6.** Verfahren nach irgendeinem der Ansprüche 1 bis 5, **dadurch gekennzeichnet, daß** das Vorbehandlungsgas darüber hinaus mindestens eine Organosiliciumverbindung enthält, die aus der Gruppe gewählt ist, die insbesondere die Silane, die Alkoxysilane, die Siloxane, die Silazane, allein oder als Gemisch miteinander, einschließt.

**7.** Verfahren nach Anspruch 6, **dadurch gekennzeichnet, daß** das Vorbehandlungsgas Hexamethyldisiloxan enthält.

**8.** Verfahren nach irgendeinem der Ansprüche 1 bis 7, **dadurch gekennzeichnet, daß** das Ablagerungsgasgemisch mindestens eine Organosiliciumverbindung und mindestens ein Gas enthält, das aus der Gruppe gewählt ist, die insbesondere Sauerstoff, Stickstoffoxid, Kohlenstoffmonoxid oder -dioxid, Wasser, Luft, die Edelgase, Stickstoff, Wasserstoff einschließt.

**9.** Verfahren nach Anspruch 8, **dadurch gekennzeichnet, daß** die Organosiliciumverbindung aus der Gruppe gewählt ist, die insbesondere die Silane, die Alkoxysilane, die Siloxane, die Silazane, allein oder als Gemisch miteinander, einschließt.

**10.** Verfahren nach Anspruch 9, **dadurch gekennzeichnet, daß** die Organosiliciumverbindung Hexamethyldisiloxan ist.

**11.** Verfahren nach irgendeinem der Ansprüche 5 bis 10, **dadurch gekennzeichnet, daß** das Vorbehandlungsgas gleich mit oder unterschiedlich zu dem Ablagerungsgasgemisch ist.

**12.** Verfahren nach irgendeinem der Ansprüche 6 bis 11, **dadurch gekennzeichnet, daß** die Organosiliciumverbindung(en) des Vorbehandlungsgases gleich mit oder unterschiedlich zu dem (denen) des Ablagerungsgasgemisches ist (sind).

13. Verfahren nach irgendeinem der Ansprüche 1 bis 12, **dadurch gekennzeichnet, daß** die Frequenz des Generators im Bereich von 0 Hz bis zu einigen GHz liegt.

14. Verfahren nach irgendeinem der Ansprüche 1 bis 13, **dadurch gekennzeichnet, daß** das Substrat aus Kunststoff aus einem verstärkten oder nichtverstärkten Polymeren besteht, das aus der Gruppe gewählt ist, die insbesondere die Polyolefine, die Polyacrylverbindungen, die Polycarbonate, die vinylaromatischen Polymeren einschließt.

15. Verfahren nach Anspruch 14, **dadurch gekennzeichnet, daß** das Substrat aus der Gruppe gewählt ist, die sich aus Polypropylen, Polystyrol, einem Methylmethacrylat-Polymeren zusammensetzt.

16. Verfahren nach Anspruch 14, **dadurch gekennzeichnet, daß** das Substrat aus Kunststoff ein Copolymeres ist, das aus Methylmethacrylat und Comonomeren gebildet ist, die aus der Gruppe gewählt sind, die sich aus (Meth)acrylsäure, den Hydroxyalkyl(meth)acrylaten, den Alkoxyalkyl(meth) acrylaten, in denen die Alkylgruppe 1 bis 8 Kohlenstoffatome hat, den (Meth)acrylnitrilen, (Meth)acrylamid, Maleinimid, Maleinsäureanhydrid, substituiertem oder nichtsubstituiertem Styrol, den Dienen zusammensetzt.

17. Verfahren nach Anspruch 14, **dadurch gekennzeichnet, daß** das Substrat ein Polymeres mit Glutarimidgruppen ist.

## FIGURE 1

## FIGURE 2

## FIGURE 3

## FIGURE 4

## FIGURE 5

PMMA

PMMA revêtu
non prétraité

PMMA revêtu prétraité
(H2O;165mW/cm3;30s)

"Haze" (%)

Nombre de tours de taber

FIGURE 6